Europäisches Patentamt

European Patent Office

Office européen des brevets

(19)

(11) Numéro de publication: **0 350 351 B1**

(12) **FASCICULE DE BREVET EUROPEEN**

(45) Date de publication de fascicule du brevet: **29.12.93** (51) Int. Cl.5: **H01L 31/10,** H01L 31/18, H01L 27/14

(21) Numéro de dépôt: **89401684.9**

(22) Date de dépôt: **15.06.89**

(54) **Photodiode et matrice de photodiodes sur matériau II-VI et leurs procédés de fabrication.**

(30) Priorité: **16.06.88 FR 8808074**

(43) Date de publication de la demande:
**10.01.90 Bulletin 90/02**

(45) Mention de la délivrance du brevet:
**29.12.93 Bulletin 93/52**

(84) Etats contractants désignés:
**DE FR GB IT**

(56) Documents cités:
**EP-A- 0 262 030**
**WO-A-87/07083**
**US-A- 4 646 120**

**SEMICONDUCTOR SCIENCE & TECHNOLO-GY, vol. 3, no. 4, 3 avril 1988, pages 377-381, IOP Publishing Ltd, Bristol, GB; C.F. BYRNE et al.: "Infrared photodiodes formed in mercury cadmium telluride grown by MOCVD"**

(73) Titulaire: **COMMISSARIAT A L'ENERGIE ATO-MIOUE**
**31/33, rue de la Fédération**
**F-75015 Paris Cédex 15(FR)**

(72) Inventeur: **Ouvrier Buffet, Jean-Louis**
**"La Planche"**
**F-74320 Sevrier(FR)**
Inventeur: **Laurent, Jean-Yves**
**3, Allée du Parc**
**F-38640 Claix(FR)**
Inventeur: **Rochas, Jean-Luc**
**16 Avenue Jean Jaurès**
**F-38320 Eybens(FR)**

(74) Mandataire: **Mongrédien, André et al**
**c/o BREVATOME**
**25, rue de Ponthieu**
**F-75008 Paris (FR)**

## Description

L'invention se rapporte à une photodiode et à une matrice de photodiodes du type photovoltaïque en matériau II-VI semi-conducteur $Hg_{1-x}Cd_xTe$ avec $0 \leq x \leq 1$, utilisées principalement pour la détection de rayonnements infrarouges.

On s'intéresse le plus souvent aux gammes spectrales adaptées aux fenêtres de transmission atmosphériques, par exemple les fenêtres de longueur d'onde de 3 à 5 micromètres ($x = 0,3$) et de 8 à 12 micromètres ($x = 0,2$). Ces fenêtres de transmission sont en effet bien adaptées à l'imagerie thermique.

Le composé HgCdTe a été universellement retenu pour la fabrication des détecteurs équipant actuellement les systèmes infrarouges de haute performance. Ce matériau permet de réaliser des mosaïques et notamment des matrices de détecteurs photovoltaïques de haute qualité à lecture électronique intégrée tout en assurant un couplage optimum au circuit de lecture avec une très faible dissipation.

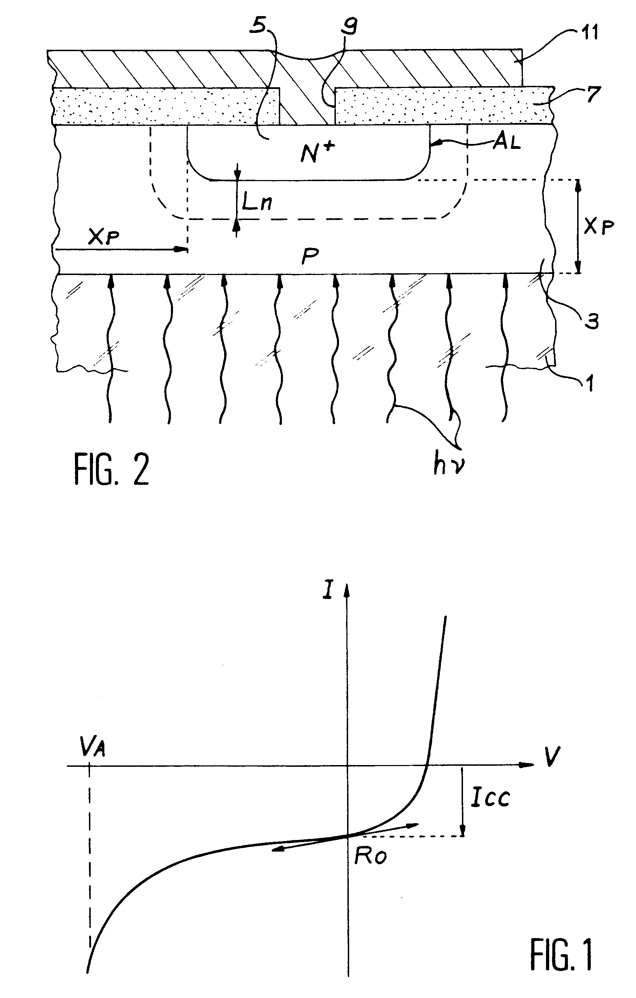

Les paramètres les plus importants auxquels doit répondre une photodiode photovoltaïque qui apparaissent sur la figure 1 annexée, représentant la caractéristique $I = f(V)$ d'une telle photodiode sont :

- un courant de court-circuit ou photocourant $I_{cc}$ fonction du flux de photons incidents, du rendement quantique et de la surface sensible de la diode,
- une résistance dynamique $R_o$ à polarisation nulle,
- une tension d'avalanche $V_A$ élevée.

Dans beaucoup d'applications, les photodiodes travaillent à polarisation nulle. Elles doivent donc présenter de grandes résistances dynamiques $R_o$ ainsi qu'un rendement quantique élevé pour assurer une grande détectivité. Or, la valeur de la résistance à l'origine $R_o$ ainsi que celle du rendement quantique dépendent fortement de la structure de la photodiode. Aussi, sur la figure 2 annexée, on a représenté une photodiode en HgCdTe à structure plane de type connu.

Cette photodiode comprend généralement, sur un substrat isolant monocristallin 1 en CdTe, une couche semi-conductrice monocristalline 3 en $Hg_{1-x}Cd_xTe$ de type P avec $0 \leq x \leq 1$. La couche monocristalline 3 comporte une région 5 de type N (ou N+) constituant la zone active de la photodiode. Elle est surmontée d'un matériau isolant 7 généralement en ZnS comportant une fenêtre 9 assurant une prise de contact électrique sur la région 5 de type N. Cette prise de contact est assurée par un plot 11 généralement en un alliage de chrome et d'or. Une telle photodiode est notamment décrite dans "Semiconductors and semimetals", volume 18 Mercury cadmium Telluride, chapitre 6, Academic Press.

Dans le cadre de l'éclairage face arrière de la photodiode, c'est-à-dire de l'éclairage par le substrat 1, comme représenté sur la figure 2, l'essentiel du courant qui traverse la jonction PN (couche 3 de type P et zone 5 de type N) provient des électrons engendrés par le rayonnement dans la région P, puis du rendement de collection de ces électrons dans cette région par l'intermédiaire de la longueur de diffusion Ln de ces électrons. Or, il est bien connu que cette longueur de diffusion des électrons Ln dépend du niveau de dopage de la région P ; plus exactement cette longueur de diffusion Ln augmente quand le niveau de dopage de la région P décroît. Elle peut en particulier être supérieure à l'épaisseur de la couche semi-conductrice 3.

Lorsque les photodiodes sont réalisées sur HgCdTe déposée sur un substrat isolant de CdTe, il est possible d'obtenir des performances en $R_o$ supérieures à celles obtenues sur matériau massif. Pour cela, il faut que l'épaisseur Xp de la région P dans toutes les directions, soit nettement inférieure à la longueur de diffusion Ln dans cette même région. Ces considérations demeurent vraies tant que la vitesse de recombinaison aux interfaces substrat-couche semi-conductrice et couche semi-conductrice-isolant 7 restent faibles, ce qui correspond à des interfaces de bonne qualité, et que leur contribution à la résistance $R_o$ proviennent des mécanismes de diffusion. En effet, $R_o$ varie avec la température de fonctionnement des photodiodes.

Toutefois, cela ne réduit pas la contribution de la surface latérale $A_l$ de la jonction à la résistance $R_o$. En effet, $R_o$ comporte deux composantes en parallèle $R_{of}$ et $R_{ol}$ satisfaisant à l'équation $1/R_o = 1/R_{of} + 1/R_{ol}$ avec $R_{of}$ la fraction de $R_o$ attribuée au fond de la jonction et $R_{ol}$ la fraction de $R_o$ attribuée à la surface latérale $A_l$ de la jonction PN.

Ces composantes sont d'une part inversement proportionnelles à la surface qu'elles mettent en jeu et d'autre part, directement proportionnelles à la valeur du rapport Ln/Xp où Xp est l'épaisseur de la région P dans la direction considérée.

Ainsi, ces expressions montrent bien la contribution de la composante latérale à la valeur de $R_o$. Par exemple, pour une photodiode de 20 x 20 $\mu m^2$ et une profondeur de la région N de 2,5 $\mu m$, la surface totale de la photodiode est de 400 $\mu m^2$ tandis que sa surface latérale est de 200 $\mu m^2$. Dans ce cas de figure avec Ln > 2Xp obtenus par une réduction de l'épaisseur de la couche 3 (Xp étant considéré dans la direction verticale de la photodiode), l'accroissement de $R_o$, déterminé expérimentalement par les inventeurs, ne dépasse pas 20 à 30 % de la valeur de $R_o$ que l'on aurait eu pour $Ln \leq Xp$, alors que l'on pourrait escompter une amélioration d'un facteur 2. En conséquence, on ne peut pas espérer augmenter de façon significative la détectivité de la photodiode en réduisant seulement l'épaisseur Xp (dans la direction verticale) de la couche semiconductrice 3.

Par ailleurs, pour assurer une grande homogénéité du photo-courant $I_{cc}$ ainsi que le meilleur rendement quantique, il faut ajuster le couple Xp-Ln. En effet, l'épaisseur de la couche semiconductrice 3 peut varier de $\pm$ 2 $\mu$m, ce qui correspond aux dispersions normales pour une épitaxie sur CdTe. Une façon de s'affranchir de ces fluctuations d'épaisseur consiste à augmenter la longueur de diffusion Ln ou ce qui revient au même à réduire le dopage de la région P.

Aussi, on a particulièrement intérêt à réaliser des photodiodes présentant une longueur de diffusion Ln des électrons engendrés dans la région P supérieure à l'épaisseur Xp de cette même région, dans toutes les directions de l'espace, tant au point de vue de $R_o$, que du rendement quantique et que des dispersions du photo-courant.

Aussi, l'invention a pour objet une photodiode présentant des performances améliorées par rapport aux photodiodes connues de l'art antérieur.

Par ailleurs, dans le cadre de la réalisation de mosaïques de photodiodes à lecture électronique intégrée devant équiper les systèmes de détection infrarouge futurs, il est souhaitable de réaliser ces mosaïques sous forme de matrices ayant une grande densité d'intégration.

L'invention a donc pour objet une photodiode en matériau II-VI semi-conducteur $Hg_{1-x}Cd_xTe$ présentant des performances en $R_o$ améliorées ainsi qu'une forte densité d'intégration.

A cet effet, l'invention se rapporte à une photodiode formée dans une couche semi-conductrice en matériau $Hg_{1-x}Cd_xTe$ d'un premier type de conductivité, avec $0\leq x\leq 1$, déposée directement sur un substrat isolant, comportant une zone dopée d'un second type de conductivité opposé au premier et s'étendant à la surface de ladite couche semi-conductrice, un premier contact électrique sur la couche semi-conductrice, un second contact électrique sur la zone dopée, un isolant séparant les premier et second contacts électriques, caractérisée en ce qu'elle comprend, en outre, une tranchée d'isolement formée dans la couche semiconductrice, isolant et entourant ladite zone dopée, présentant une profondeur supérieure à l'épaisseur de ladite zone dopée mais inférieure à l'épaisseur de la couche semi-conductrice, le premier contact électrique étant formé dans le fond de la tranchée et s'étendant le long de toute la tranchée.

Cette photodiode peut être utilisée soit en éclairage par la face arrière (face du substrat) soit en éclairage par la face avant (face opposée au substrat).

L'utilisation d'une tranchée d'isolement ayant une profondeur supérieure à l'épaisseur de la zone dopée permet d'augmenter $R_{oI}$, et donc $R_o$, par diminution de l'épaisseur Xp latéralement.

L'invention a aussi pour objet une matrice de photodiodes comportant des photodiodes telles que décrites ci-dessus, les tranchées assurant l'isolement entre les photodiodes adjacentes et les premiers contacts électriques de ces photodiodes étant tous reliés électriquement entre eux.

Dans l'article de J.F. Kim et al. "Crosstalk measurements on a linear area of deep U-grooves isolated silicon photodiodes", Optical Ingeenering, de septembre-octobre 1983, vol. 22, n° 5, pp. 656-659, il est connu d'isoler électriquement les unes des autres des photodiodes réalisées sur du silicium massif à l'aide de tranchées d'isolement en vue de minimiser la détection de rayonnements parasites. Ces tranchées ne sont réalisées que dans une seule direction de la surface de détection. Dans cet article, les photodiodes consistent en une région P isolée en une région médiane commune N et un substrat de type P commun. La prise de contact sur les régions N, reliées électriquement entre elles, est effectuée sur l'une des faces latérales de l'ensemble de photodiodes.

Il est aussi connu par les documents WO-A-87/07083 et US-A-4 646 120 de réaliser des tranchées d'isolement autour des zones actives des photodiodes d'une matrice de photodiodes. Dans ces documents, on utilise trois couches semiconductrices superposées afin de réaliser un contact électrique périphérique, commun à toutes les zones P des photodiodes.

On sait que le contact de type P des photodiodes doit être réalisé dans une région fortement dopée alors que l'obtention d'un détecteur performant nécessite l'utilisation d'une région P peu dopée. D'où l'utilisation dans ces documents, d'une couche de type P fortement dopée supportant une couche de type P moins dopée puis une couche de type N pour réaliser la jonction PN.

Selon l'invention, la réalisation du contact électrique de la couche semi-conductrice dans le fond des tranchées permet, en plus des avantages donnés ci-dessus, une augmentation de la densité d'intégration des photodiodes dans le cas d'une mosaïque de photodiodes.

En effet, une prise de contact sur la couche semi-conductrice et sur la zone active, réalisée à la fois à la surface de chaque photodiode (ou en face avant), comme décrit dans le document FR-A-2 604 298 déposé au nom du demandeur, nécessite de conserver une garde suffisante entre les prises de contact afin d'éviter un court-circuit. En outre, cette solution conduit à une réduction de la surface sensible des photodiodes au profit des contacts électriques et donc une diminution du courant de court-circuit et de la détectivité des photodiodes.

Le premier type de conductivité peut être le type P ou le type N et inversement le second type de conductivité le type N ou P. Les matériaux utilisables pour la réalisation des premier et second contacts électriques dépendent principalement du type de dopage de la couche semi-conductrice. Pour un dopage P, les contacts électriques sont réalisés en or, en cuivre ou en un matériau bicouche chrome-or, et pour un dopage N, ces contacts sont généralement en aluminium.

Selon l'invention, l'amélioration des performances en $R_o$ est d'autant plus importante que les tranchées sont profondes, en particulier 2 à 3 fois supérieure à l'épaisseur de la zone dopée, mais en contrepartie, la résistance d'accès à la photodiode augmente. Aussi, la réalisation du premier contact électrique au fond de la tranchée, selon l'invention, permet de réduire cette résistance d'accès.

L'invention a aussi pour objet un procédé de fabrication d'une photodiode consistant à :

a) pratiquer une tranchée dans une couche semi-conductrice en matériau $Hg_{1-x}Cd_xTe$ d'un premier type de conductivité, déposée directement sur un substrat isolant, isolant ainsi une zone semi-conductrice, la tranchée ayant une profondeur inférieure à l'épaisseur de la couche semi-conductrice et entourant ladite zone semi-conductrice,

b) déposer un matériau isolant sur l'ensemble de la structure,

c) pratiquer une première ouverture de la couche d'isolant dans le fond de la tranchée,

d) remplir la tranchée d'un matériau de protection,

e) implanter des ions d'un second type de conductivité dans la zone semiconductrice, l'épaisseur de la zone ainsi dopée étant inférieure à la profondeur de la tranchée,

f) pratiquer une seconde ouverture du matériau isolant en regard de la zone dopée,

g) éliminer le matériau de protection,

h) réaliser un premier contact électronique dans le fond de la tranchée s'étendant le long de toute la tranchée (15) et simultanément un second contact électrique en regard de la zone dopée.

Ce procédé a l'avantage d'être beaucoup plus simple que ceux de l'art antérieur tout en assurant des performances en $R_o$ améliorées et une densité d'intégration plus forte que celles de l'art antérieur.

Afin d'obtenir des tranchées profondes dont les flancs sont les plus verticaux possibles, on utilise soit un procédé de gravure planaire, anisotrope, après avoir réalisé un masque principalement en résine photosensible à la surface du matériau semiconducteur définissant l'emplacement, la largeur et la longueur des tranchées, soit en utilisant un usinage ionique.

De préférence, on utilise l'usinage ionique ; les ions utilisés sont principalement des ions de gaz rares tels que des ions d'argon, de krypton ou de xénon.

Avantageusement, les tranchées sont plus profondes que larges ce qui permet d'éviter, lors de la réalisation des contacts sur le substrat, de déposer du métal sur les parois des tranchées. En particulier, les tranchées ont une profondeur 2 à 3 fois supérieure à leur largeur.

En vue de fixer le niveau de dopage de la couche semi-conductrice du premier type de conductivité, et par conséquent la longueur de diffusion des porteurs dans cette couche (électrons pour un matériau de type P et trous pour un matériau de type N) et simultanément de guérir les défauts introduits dans cette couche lors de l'usinage ionique, on effectue un recuit thermique de la structure entre 200 et 300°C. Un tel traitement thermique est en particulier décrit dans le document FR-A-2 604 298. Dans le cas d'un matériau de type P, ce traitement thermique permet de ramener les régions de type N induites par le bombardement ionique à une conductivité de type P.

En vue de surdoper, conformément à l'invention, la couche semi-conductrice du premier type de conductivité sous les tranchées d'isolement, on dépose au fond des tranchées une couche métallique contenant des ions dopants du même type de conductivité que la couche semi-conductrice, ce dépôt étant effectué juste avant de remplir les tranchées du matériau de protection. Ce surdopage permet de réduire la résistance d'accès du contact et surtout de donner un caractère ohmique à celui-ci.

La couche métallique contenant les ions dopants permet en plus d'empêcher l'exodiffusion des constituants de la couche semi-conductrice tels que le mercure, lors du traitement thermique.

Au lieu d'utiliser une couche métallique dans le fond des tranchées, il est possible d'éviter l'exodiffusion du mercure, lors du traitement thermique, en effectuant ce traitement, de façon connue, sous atmosphère de mercure dans une ampoule scellée.

L'isolant utilisé pour isoler électriquement les deux contacts électriques de chaque photodiode peut être réalisé sous forme d'une simple couche isolante par exemple en SiO, $SiO_2$, ZnS, CdTe, $Si_3N_4$, ou encore d'une double couche isolante afin d'assurer la meilleure interface possible entre le matériau semiconducteur et les contacts électriques ainsi que les meilleures propriétés isolantes du matériau. Le matériau isolant présente une épaisseur allant de 100 à 1 000 nm.

De préférence le matériau isolant est déposé par pulvérisation cathodique radiofréquence du fait que cette technique permet l'obtention d'un isolant de bonne qualité. Or, suivant cette technique, il n'était pas évident que la couverture du fond et des flancs des tranchées soit possible du fait que ces dernières ont une profondeur supérieure à leur largeur (de préférence 2 à 3 fois supérieure).

Afin d'augmenter le taux de recouvrement de l'isolant il est possible de polariser le support conducteur supportant les photodiodes, lors de la pulvérisation de l'isolant, ce support étant relié à un générateur radiofréquence ou continu. Ce procédé de polarisation bien connu de l'homme de l'art est connu sous l'abréviation BIAS.

D'autres caractéristiques et avantages de l'invention ressortiront mieux de la description qui va suivre, donnée à titre illustratif et non limitatif.

La description se réfère aux dessins annexés dans lesquels :

- la figure 1, déjà décrite, est une courbe donnant les variations du courant I en fonction de la tension V appliquée aux bornes d'une photodiode photovoltaïque en HgCdTe, selon l'art antérieur,
- la figure 2, déjà décrite, représente schématiquement une photodiode photovoltaïque en HgCdTe à structure plane illustrant l'état de la technique,
- les figures 3 à 11 illustrent schématiquement les différentes étapes du procédé de fabrication d'une mosaïque de photodiodes conforme à l'invention ; les figures 3 et 10 sont des vues en perspective et les figures 4 à 9 et 11 des vues en coupe selon le plan A-A de la figure 3.

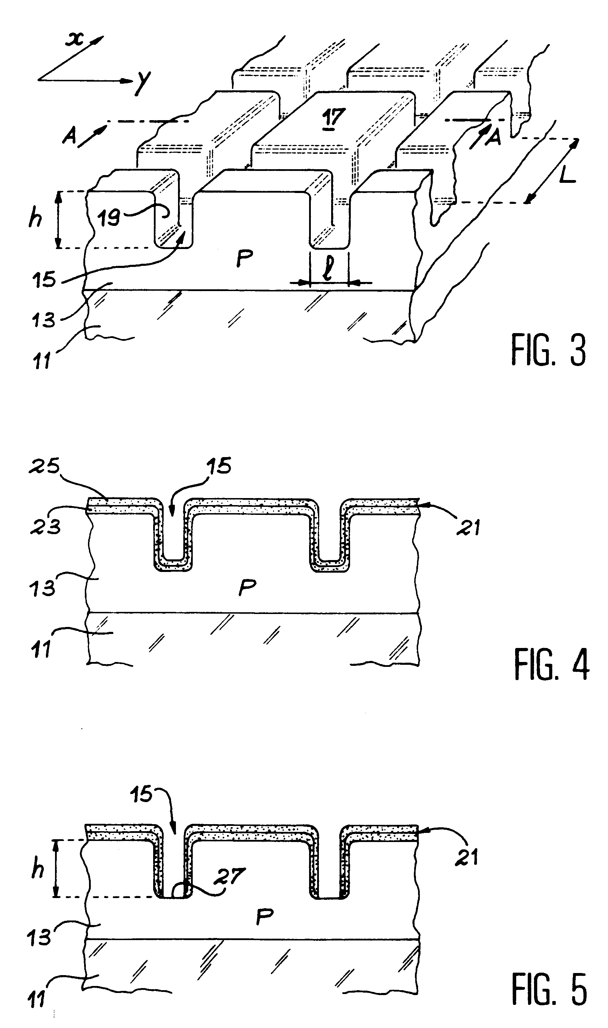

La première étape du procédé consiste, comme représenté sur la figure 3, à déposer directement sur un substrat isolant monocristallin 11, transparent aux rayonnements infrarouges, une couche semiconductrice 13 monocristalline. Le substrat 11 est soit du saphir soit du CdTe. La couche semiconductrice 13 en $Hg_{1-x}Cd_xTe$, avec x allant de 0 à 1 et en particulier allant de 0,2 à 0,3, peut être épitaxiée par pulvérisation cathodique en plasma de mercure ou par épitaxie en phase liquide (EPL). Cette couche 13 de type P présente une épaisseur allant de 6 à 10 $\mu$m.

Selon l'invention, on effectue un usinage ionique de la couche semiconductrice 13 en vue de former des tranchées 15 dans les deux directions x et y contenues dans le plan de la couche 13. Ces tranchées 15 sont effectuées de façon qu'il reste, sous les tranchées, du matériau semi-conducteur de la couche 13. Autrement dit, la profondeur h de ces tranchées est inférieure à l'épaisseur de la couche 13. Ces tranchées 15 présentent une profondeur h de 3 à 8 $\mu$m, une largeur l de 2 à 5 $\mu$m. La longueur L de ces tranchées est comprise entre 5 à 50 $\mu$m.

Ces tranchées définissent des zones semiconductrices 17 de longueur L et de largeur l, isolées les unes des autres. L'usinage ionique peut être réalisé avec un courant d'ions de 500 nA/cm² et une énergie de 500 eV entraînant une vitesse de gravure du HgCdTe voisine de 200 nm/mn. Ces performances sont obtenues avec le dispositif commercialisé sous le nom de "Microetch" produit par la société Veeco Instruments. En procédant de cette façon, la pente de la gravure est très forte, supérieure à 80°. Autrement dit les flancs 19 des tranchées sont pratiquement verticaux.

Après cette étape de gravure, on effectue éventuellement un premier traitement thermique entre 200 et 300°C afin de fixer le niveau de dopage de type P dans la couche 13 et donc la longueur de diffusion Ln des électrons dans cette couche. De surcroît, ce traitement thermique assure la régénération des zones de la couche 13 située à proximité et au contact des tranchées 15.

On dépose ensuite, comme représenté sur la figure 4, par pulvérisation cathodique radiofréquence, un matériau isolant 21 formé avantageusement d'une première couche 23 en CdTe recouverte d'une seconde couche 25 en ZnS. L'utilisation d'une couche 23 en CdTe améliore la qualité de l'interface de l'isolant du fait de ses compatibilités chimique et cristallographique avec le matériau semiconducteur de la couche 13. Le matériau 21 a une épaisseur de l'ordre de 500 nm. Ce dépôt 21 est effectué avantageusement en polarisant le support conducteur (non représenté) supportant le substrat 11 avec un générateur RF ou continu.

L'étape suivante du procédé comme représenté sur la figure 5 consiste à dégager, en particulier à l'usineur ionique avec des ions de Ar⁺, le fond 27 des tranchées 15 par autopositionnement (technique connue sous le nom anglo-saxon de self-alignment). Du fait de la profondeur des tranchées (au moins 2 fois supérieure à leur largeur), l'épaisseur du matériau isolant 21 est au moins deux fois plus faible au fond des tranchées que sur la surface de la couche semi-conductrice 13 ; l'usinage ionique met donc à nu uniquement le fond 27 des tranchées.

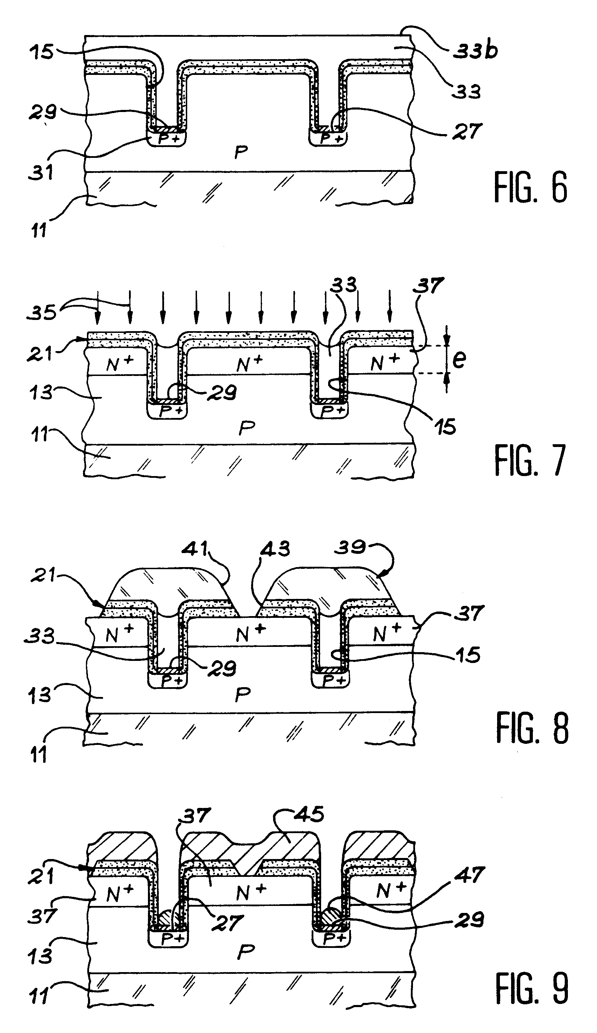

On effectue ensuite avantageusement, comme représenté sur la figure 6, le dépôt d'une couche métallique 29 dans le fond 27 de chaque tranchée, contenant des ions dopants de type P. Ce dépôt métallique 29 a une épaisseur de 10 à 100 nm et est en particulier en or ou en cuivre. Ce dépôt est effectué par pulvérisation cathodique radiofréquence.

On effectue ensuite un second traitement thermique entre 200 et 300°C entraînant en outre la diffusion locale d'or ou de cuivre dans la couche semiconductrice 13 et par conséquent, la formation d'une région surdopée de type P⁺ 31 juste sous chaque tranchée d'isolement 15. Cette technique permet en particulier d'obtenir des zones 31 dopées avec $10^{18}$ à $10^{20}$ ions/$cm^2$ au lieu de $10^{16}$ ions/$cm^2$ pour la couche 13. Ces zones 31 peuvent s'étendre jusqu'au substrat 11.

Dans le cas éventuel d'un unique traitement thermique, ce "second" traitement permet la fixation du niveau de dopage P et la régénération des zones semi-conductrices perturbées lors de l'usinage des tranchées.

On effectue ensuite, comme représenté sur la figure 6, le dépôt d'une résine suffisamment visqueuse et épaisse 33, telle que celle classiquement utilisée en photolithographie (résine phénolformaldéhyde) dont l'épaisseur est supérieure à celle de la profondeur des tranchées afin de remplir ces dernières et obtenir une surface plane 33b. L'étalement de cette résine peut être amélioré en effectuant un traitement thermique à 150°C pendant 15 min. On effectue ensuite soit une insolation superficielle de toute la résine 33 puis un développement, soit une gravure directe de cette résine par plasma $O_2$, de façon à ne conserver de la résine qu'à l'intérieur des tranchées 15 comme représenté sur la figure 7. Cette résine assure une protection du fond des tranchées lors de l'étape suivante.

On effectue alors une implantation ionique 35 afin d'obtenir des zones implantées de type N ou $N^+$ 37 dans la couche semi-conductrice 13, le restant de la résine 33 servant de masque à cette implantation. Cette implantation est effectué avec des ions de bore à une dose de $10^{12}$ à $10^{15}$ ions/$cm^2$ et une énergie de 50 à 200 keV. On obtient ainsi des zones implantées 37 de 1 à 5 $\mu$m d'épaisseur e, soit deux à trois fois plus petites que la profondeur h des tranchées 15.

L'étape suivante du procédé consiste, comme représenté sur la figure 8, à réaliser un masque de lithographie 39 à la surface de la structure, tout en maintenant le restant de la résine 33 dans les tranchées 15. Ce masque 39 définit l'emplacement des contacts électriques à réaliser sur les zones dopées 37 ainsi que la dimension (largeur et longueur) de ces contacts électriques. Ce masque 39 est réalisé par dépôt d'une couche de résine telle que celle classiquement utilisée en microélectronique (résine AZ 1350) que l'on insole puis développe afin de former une ouverture 41. Un traitement thermique de la structure obtenue permet de faire fluer la résine 39 et d'obtenir une ouverture 41 dont les flancs sont inclinés, par rapport à la normale à la surface de la structure, de 30 à 40°. On effectue alors une abrasion ionique des régions du matériau isolant 21 exposées, en vue d'obtenir des ouvertures 43 à flancs inclinés dans ce matériau. L'abrasion ionique est effectuée avec un courant d'ions d'argon de 500 nA/$cm^2$ et une énergie de 500 eV.

L'étape suivante du procédé consiste à éliminer le masque de résine 39 ainsi que la résine 33 restante à l'aide d'un plasma d'oxygène.

On effectue alors, comme représenté sur la figure 9, le dépôt par évaporation Joule des contacts électriques 45 et 47 respectivement sur les régions implantées 37 et sur le fond 27 des tranchées d'isolement. Ces contacts électriques sont en particulier un matériau bicouche de chrome et d'or de 1000 nm d'épaisseur. Cette technique d'évaporation permet d'obtenir des contacts électriques sans franchissement de marches du fait que celles-ci sont de forte amplitude et très étroites. En outre, cette technique permet d'obtenir des contacts 47 tous reliés électriquement entre eux.

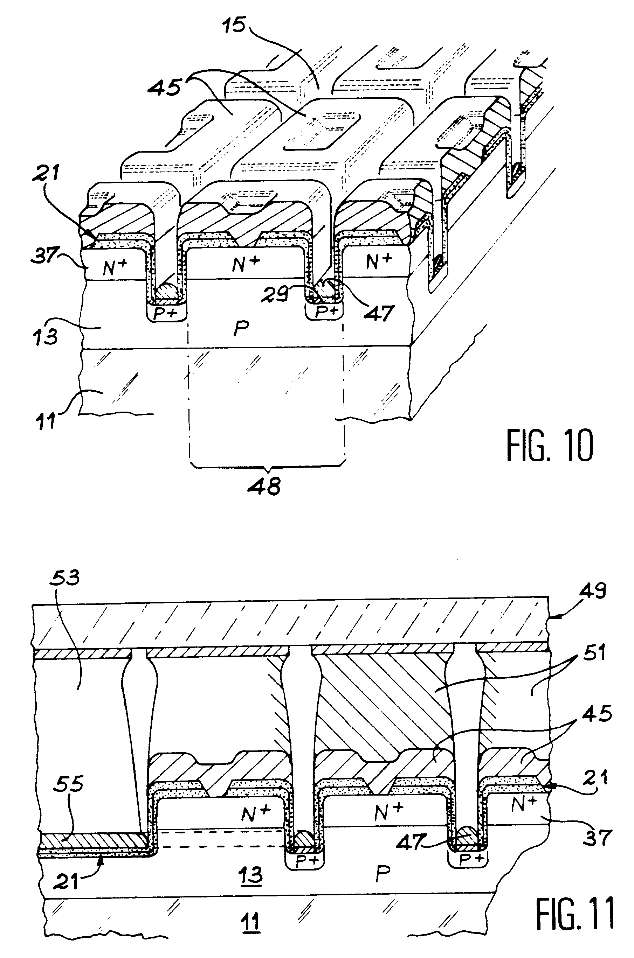

La figure 10 montre la matrice de photodiodes 48 ainsi réalisée.

La lecture et l'adressage des photodiodes 48 ainsi obtenues, séparées par les tranchées 15, sont assurées par le circuit de lecture et d'adressage intégré, schématisé en 49 sur la figure 11. A cet effet, chaque contact 45 est relié au circuit 49 par un plot d'indium 51. Par ailleurs, les contacts 47 sont reliés au circuit 49 par au moins un plot d'indium 53 grâce à un contact métallique 55 situé à la périphérie de la matrice et fabriqué en même temps que les contacts 47. Le contact périphérique 55 est réalisé sur une plage importante de la couche semi-conductrice 13 gravée et en est séparée, dans le mode particulier de réalisation décrit, par le matériau isolant 21.

La description ci-dessus portait sur la fabrication de photodiodes dans une couche semiconductrice de type P. Bien entendu, il est possible de concevoir des photodiodes dans une couche semi-conductrice de type N ; dans ce cas, les régions surdopées 31 sont obtenues par épitaxie en phase liquide dopé avec In, les zones dopées 37 par implantation de phosphore et les contacts électriques 45 et 47 sont en aluminium.

**Revendications**

1. Photodiode (48) formée dans une couche semi-conductrice (13) en $Hg_{1-x}Cd_xTe$ d'un premier type de conductivité (P), avec $0 \leq x \leq 1$, déposée directement sur un substrat isolant (11), comportant une zone dopée (37) d'un second type de conductivité opposé (N) au premier et s'étendant à la surface de ladite couche semi-conductrice (13), un premier contact électrique (47) sur la couche semi-conductrice, un second contact électrique (45) sur ladite zone dopée (37), un isolant (21) séparant les premier (47) et second (45) contacts électriques, caractérisée en ce qu'elle comporte en outre une tranchée d'isolement (15), formée dans la couche semi-conductrice (13), isolant et entourant toute ladite zone dopée (37), présentant une profondeur (h) supérieure à l'épaisseur (e) de ladite zone dopée (37) mais inférieure à l'épaisseur de la couche semi-conductrice (13), le premier contact électrique (47) étant formé dans le fond (27) de la tranchée (15) et s'étendant le long de toute la tranchée (15).

2. Photodiode selon la revendication 1, caractérisée en ce qu'elle comporte en outre une zone surdopée (31) du premier type de conductivité ($p^+$) sous la tranchée d'isolement (15).

3. Photodiode selon la revendication 1 ou 2, caractérisée en ce qu'elle comporte, au fond (27) de la tranchée (15), une couche métallique (29) contenant des ions dopants du premier type de conductivité ($p^+$).

4. Photodiode selon l'une quelconque des revendications 1 à 3, caractérisée en ce que la profondeur (h) de la tranchée (15) est 2 à 3 fois supérieure à l'épaisseur (e) de ladite zone dopée (37).

5. Photodiode selon l'une quelconque des revendications 1 à 4, caractérisée en ce que le premier type de conductivité est le type P et le second type est le type N.

6. Photodiode selon la revendication 5, caractérisée en ce que le premier contact électrique (47) est en or, en cuivre ou en un matériau bicouche chrome-or.

7. Photodiode selon la revendication 3, caractérisée en ce que la couche métallique (29) est en or.

8. Photodiode selon l'une quelconque des revendications 1 à 7, caractérisée en ce que le substrat isolant (11) est du CdTe.

9. Photodiode selon l'une quelconque des revendications 1 à 8, caractérisée en ce que la tranchée (15) a une profondeur supérieure à sa largeur.

10. Matrice de photodiodes, caractérisée en ce que les photodiodes (48) sont conformes à l'une quelconque des revendications 1 à 9, les tranchées (15) assurant l'isolement entre les photodiodes adjacentes, et en ce que les premiers contacts électriques (47) sont tous reliés entre eux.

11. Matrice selon la revendication 10, caractérisée en ce que les flancs des tranchées sont pratiquement verticaux.

12. Procédé de fabrication d'une photodiode (48) selon la revendication 1 consistant à :
    a) pratiquer une tranchée (15) dans une couche semi-conductrice (13) de $Hg_{1-x}Cd_xTe$ d'un premier type de conductivité (P), avec $0 \leq x \leq 1$, déposée directement sur un substrat isolant (11), isolant ainsi une zone semiconductrice (17), la tranchée (15) ayant une profondeur (h) inférieure à l'épaisseur de la couche semi-conductrice et entourant ladite zone semi-conductrice (17),
    b) déposer un matériau isolant (21) sur l'ensemble de la structure,
    c) pratiquer une première ouverture de la couche d'isolant (21) dans le fond (27) de la tranchée (15),
    d) remplir la tranchée (15) d'un matériau (33) de protection,
    e) implanter (35) des ions d'un second type de conductivité (N) dans la zone semiconductrice (17), l'épaisseur (e) de la zone ainsi dopée (37) étant inférieure à la profondeur (h) de la tranchée (15),
    f) pratiquer une seconde ouverture (43) du matériau isolant (21) en regard de la zone dopée (37),
    g) éliminer le matériau de protection (33),
    h) réaliser un premier (47) contact électrique dans le fond (27) de la tranchée (15) s'étendant le long de toute la tranchée (15) et simultanément un second (45) contact électrique en regard de la zone dopée (37).

13. Procédé de fabrication selon la revendication 12, caractérisé en ce que le premier type de conductivité est le type P et le second type est le type N.

14. Procédé de fabrication selon la revendication 12 ou 13, caractérisé en ce que l'étape a) consiste à usiner ioniquement la couche semi-conductrice (13).

15. Procédé de fabrication selon l'une quelconque des revendications 12 à 14, caractérisé en ce que l'on effectue un recuit thermique de la structure afin de fixer le dopage de la couche semi-conductrice (13).

16. Procédé de fabrication selon l'une quelconque des revendications 12 à 15, caractérisé en ce que l'on dépose une couche métallique (29) contenant des ions dopants du premier type de conductivité (P) au fond (27) de la tranchée, entre les étapes c) et d).

17. Procédé de fabrication selon l'une quelconque des revendications 12 à 16, caractérisé en ce que la seconde ouverture (43) présente des flancs inclinés.

18. Procédé de fabrication selon l'une quelconque des revendications 12 à 17, caractérisé en ce que les premier et second contacts électriques (47, 45) sont formés par évaporation Joule.

19. Procédé de fabrication selon l'une quelconque des revendications 12 à 18, caractérisé en ce que l'on dépose le matériau isolant (21) sous forme d'au moins une couche (23, 25) par pulvérisation cathodique.

## Claims

1. Photodiode (48) formed in a semiconductor layer (13) of $Hg_{1-x}Cd_xTe$ material of a first conductivity type (P), with $0 \leq x \leq 1$, deposited directly on an insulating substrate (11), having a doped zone (37) of a second conductivity type (N) opposite to the first and extending on the surface of said semiconductor layer, a first electrical contact (47) on the semiconductor layer, a second electrical contact (45) on the doped zone (37), an insulant (21) separating the first (47) and second (45) electrical contacts, characterized in that it also comprises an insulating trench (15) formed in the insulating semiconductor layer (13) and surrounding said doped zone (37), having a depth exceeding the thickness of said doped zone (37), but less than the thickness of the semiconductor layer (13), the first electrical contact (47) being formed in the bottom (27) of the trench (15) and extending along the entire trench (15).

2. Photodiode according to claim 1, characterized in that it also has an overdoped zone (31) of the first conductivity type ($p^+$) beneath the insulation trench (15).

3. Photodiode according to claim 1 or 2, characterized in that, at the bottom (27) of trench (15), it has a metallic layer (29) containing doping ions of the first conductivity type ($p^+$).

4. Photodiode according to any one of the claims 1 to 3, characterized in that the depth (h) of the trench (15) is two to three times greater than the thickness (e) of said doped zone (37).

5. Photodiode according to any one of the clams 1 to 4, characterized in that the first conductivity type is of type P and the second conductivity type is of type N.

6. Photodiode according to claim 5, characterized in that the first electrical contact (47) is of gold, copper or a two-layer chromium-gold material.

7. Photodiode according to claim 3, characterized in that the metallic layer (29) is of gold.

8. Photodiode according to any one of the claims 1 to 7, characterized in that the insulating substrate (11) is of CdTe.

9. Photodiode according to any one of the claims 1 to 8, characterized in that the depth of the trench (15) is greater than its width.

10. Array of photodiodes, characterized in that the photodiodes (48) are produced in accordance with any one of the claims 1 to 9, the trenches (15) providing the insulation between adjacent photodiodes and in that the first electrical contacts (47) are all interconnected.

11. Array according to claim 10, characterized in that the sides of the trenches are substantially vertical.

12. Process for producing a photodiode (48) according to claim 1 comprising:
    a) making a trench (15) in a semiconductor layer (13) of $Hg_{1-x}Cd_xTe$ of a first conductivity type (P), with $0 \leq x \leq 1$, directly deposited on an insulating substrate (11), thus insulating a semiconductor zone (17), the trench (15) having a depth (h) less than the thickness of the semiconductor layer and surrounding said semiconductor zone (17),
    b) depositing an insulating material (21) on the complete structure,
    c) making a first opening of the insulating layer (21) in the bottom (27) of the trench (15),
    d) filling the trench (15) with a protective material (33),
    e) implanting (35) ions of a second conductivity type (N) in the semiconductor zone (17), the thickness (e) of the thus doped zone (37) being less than the depth (h) of the trench,
    f) making a second opening (43) of the insulating material (21) facing the doped zone (37),
    g) eliminating the protective material (33),

h) making a first (47) electrical contact respectively in the bottom (27) of the trench (15) and all along the trench (15) and simultaneously a second electrical contact (45) facing the doped zone (37).

13. Production process according to claim 12, characterized in that the first conductivity type is of the P type and the second conductivity type is of the N type.

14. Production process according to claim 12 or 13, characterized in that stage a) consists of ionically working the semiconductor layer (13).

15. Production process according to any one of the claims 12 to 14, characterized in that annealing of the structure takes place in order to fix the doping of the semiconductor layer (13).

16. Production process according to any one of the claims 12 to 15, characterized in that a metallic layer (29) containing doping ions of the first conductivity type (P) is deposited at the bottom (27) of the trench between stages c) and d).

17. Production process according to any one of the claims 12 to 16, characterized in that the second opening (43) has inclined sides.

18. Production process according to any one of the claims 12 to 17, characterized in that the first and second electrical contacts (47, 45) are formed by Joule evaporation.

19. Production process according to any one of the claims 12 to 18, characterized in that the insulating material (21) is deposited in the form of at least one layer (23, 25) by cathodic sputtering.

**Patentansprüche**

1. Photodiode (48), gebildet in einer Halbleiterschicht (13) aus $Hg_{1-x}Cd_xTe$ eines ersten Konduktivitätstyps (P), mit $O \leq x \leq 1$, direkt auf ein isolierendes Substrat (11) aufgebracht, umfassend eine dotierte Zone (37) eines zweiten, dem ersten entgegengesetzten Konduktivitätstyps (N), einen ersten elektrischen Kontakt (47) auf der Halbleiterschicht, einen zweiten elektrischen Kontakt (45) auf der genannten dotierten Zone (37), einen Isolator (21), der den ersten (47) und den zweiten (45) elektrischen Kontakt trennt,
dadurch **gekennzeichnet**,
daß sie außerdem eine Isolierrinne (15) umfaßt, ausgebildet in der Halbleiter-Isolierschicht (13) und die gesamte dotierte Zone (37) umgebend, dabei eine Tiefe (h) aufweisend, die größer ist als die Dicke der genannten dotierten Zone (37), aber kleiner als die Dicke der Halbleiterschicht (13), wobei der erste elektrische Kontakt (47) gebildet wird im Boden (27) der Rinne (15), und sich über die gesamte Länge der Rinne (15) erstreckt.

2. Photodiode nach Anspruch 1, dadurch gekennzeichnet, daß sie außerdem, unter der Isolierrinne (15), eine Zone (31) des ersten Konduktivitätstyps ($p^+$) enthält.

3. Photodiode nach Anspruch 1 oder 2, dadurch gekennzeichnet, daß sie am Boden (27) der Rinne (15) eine Metallschicht (29) aufweist, die dotierende Ionen des ersten Konduktivitätstyps ($p^+$) enthält.

4. Photodiode nach einem der Ansprüche 1 bis 3, dadurch gekennzeichnet, daß die Tiefe (h) der Rinne (15) zwei- bis dreimal größer ist als die Dicke (e) der genannten dotierten Zone (37).

5. Photodiode nach einem der Ansprüche 1 bis 4, dadurch gekennzeichnet, daß der erste Konduktivitätstyp vom P-Typ ist, und der zweite vom N-Typ ist.

6. Photodiode nach Anspruch 5, dadurch gekennzeichnet, daß der erste elektrische Kontakt (47) aus Gold, Kupfer oder aus einem zweischichtigen Material Chrom-Gold ist.

7. Photodiode nach Anspruch 3, dadurch gekennzeichnet, daß die Metallschicht (29) aus Gold ist.

8. Photodiode nach einem der Ansprüche 1 bis 7, dadurch gekennzeichnet, daß das isolierende Substrat (11) CdTe ist.

9. Photodiode nach einem der Ansprüche 1 bis 8, dadurch gekennzeichnet, daß die Rinne 15 eine Tiefe aufweist, größer als ihre Breite.

10. Photodioden-Matrix, dadurch gekennzeichnet, daß die Photodioden (48) einem der Ansprüche 1 bis 9 entsprechen, die Rinnen (15) die Isolierung gewährleisten zwischen den benachbarten Dioden, und dadurch, daß die ersten elektrischen Kontakte (47) alle untereinander verbunden sind.

11. Matrix nach Anspruch 10, dadurch gekennzeichnet, daß die Flanken der Rinnen praktisch vertikal sind.

12. Herstellungsverfahren einer Photodiode (48) nach Anspruch 1, bestehend aus folgenden Schritten:

a) Herstellen einer Rinne (15) in einer Halbleiterschicht (13) aus $Hg_{1-x}Cd_xTe$ eines ersten Konduktivitätstyps (P), mit $O \leq x \leq 1$, aufgebracht direkt auf ein isolierendes Substrat (11), somit eine Halbleiterzone 17 isolierend, wobei die Rinne eine Tiefe (h) kleiner als die Dicke der Halbleiterschicht hat und die genannte Halbleiterzone (17) umgibt,

b) Aufbringen eines isolierenden Materials 21 auf die Gesamtheit der Struktur,

c) Herstellen einer ersten Öffnung der Isolierschicht (21) im Boden (27) der Rinne (15),

d) Füllen der Rinne (15) mit einem Schutzmaterial,

e) Implantieren (35) von Ionen eines zweiten Konduktivitätstyps (N) in die Halbleiterzone (17), wobei die Dicke (e) der so dotierten Zone (37) kleiner ist als die Tiefe (h) der Rinne (15),

f) Herstellen einer zweiten Öffnung (43) des Isoliermaterials (21), der dotierten Zone (37) gegenüber,

g) Beseitigen des Schutzmaterials (33),

h) Herstellen eines ersten (47) elektrischen Kontakts im Boden (27) der Rinne (15), der sich über die gesamte Länge der Rinne (15) erstreckt, und gleichzeitig eines zweiten (45) elektrischen Kontakts, der dotierten Zone (37) gegenüber.

13. Herstellungsverfahren nach Anspruch 12, dadurch gekennzeichnet, daß der erste Konduktivitätstyp der P-Typ ist, und der zweite der N-Typ ist.

14. Herstellungsverfahren nach Anspruch 12 oder 13, dadurch gekennzeichnet, daß der Schritt a) darin besteht, die Halbleiterschicht (13) ionisch zu bearbeiten.

15. Herstellungsverfahren nach einem der Ansprüche 12 bis 14, dadurch gekennzeichnet, daß man ein thermisches Glühen der Struktur durchführt, um die Dotierung der Halbleiterschicht (13) zu fixieren.

16. Herstellungsverfahren nach einem der Ansprüche 12 bis 15, dadurch gekennzeichnet, daß man zwischen den Schritten c) und d) auf den Boden der Rinne (27) eine Metallschicht (29) aufbringt, die dotierende Ionen des ersten Konduktivitätstyps P enthält.

17. Herstellungsverfahren nach einem der Ansprüche 12 bis 16, dadurch gekennzeichnet, daß die zweite Öffnung (43) geneigte Flanken aufweist.

18. Herstellungsverfahren nach einem der Ansprüche 12 bis 17, dadurch gekennzeichnet, daß die ersten und zweiten elektrischen Kontakte (47, 45) durch Joulesche Verdampfung gebildet werden.

19. Herstellungsverfahren nach einem der Ansprüche 12 bis 18, dadurch gekennzeichnet, daß man das Isoliermaterial (21) in Form von wenigstens einer Schicht (23, 25) durch kathodische Pulverisierung aufbringt.

FIG. 2

FIG. 1

FIG. 3

FIG. 4

FIG. 5

FIG. 6

FIG. 7

FIG. 8

FIG. 9

15

45

21

37

N⁺ N⁺ N⁺

29

P+ P+ 47

13

P

11

48

**FIG. 10**

53

49

51

45

21

55

21

N⁺ N⁺ N⁺

47

37

P+ P+

13

P

11

**FIG. 11**